# EUROPEAN PATENT SPECIFICATION

(11) **EP 4 589 656 B1**
(45) Date of publication and mention of the grant of the patent: **20.05.2026**
(21) Application number: 24187768.7
(22) Date of filing: 10.07.2024
(51) Int. Cl.: H10H 20/813, H10H 20/815, H10H 29/14

(54) **LIGHT EMITTING DIODE**
LEUCHTDIODE
DIODE ÉLECTROLUMINESCENTE

(30) Priority: 16.01.2024 TW 113101665
(43) Date of publication of application: 23.07.2025
(73) Proprietor: Taiwan-Asia Semiconductor Corporation, Hsinchu City 30078 (TW)
(72) Inventor: Chen, Ya-Chun, 30078 Hsinchu City (TW); Lin, Yi-Jen, 30078 Hsinchu City (TW); Wang, Tzu-Wen, 30078 Hsinchu City (TW)
(74) Representative: Michalski Hüttermann & Partner Patentanwälte mbB

(56) References cited:
- US-A1- 2007 170 444
- US-A1- 2010 224 857
- US-A1- 2021 296 528
- US-A1- 2022 085 250
- US-B2- 8 598 598

## Description

### BACKGROUND OF THE INVENTION

### 1. Field of the Invention

The present invention relates to a light emitting diode, especially a light emitting diode with a plurality of light emitting units.

### 2. Description of Related Art

In recent years, light emitting diodes have been widely applied in various fields or products with lighting requirements. Currently, common light emitting diodes produce an electroluminescence effect to convert electrical energy into light energy, mainly by electric currents passing through a connection surface between two different semiconductor materials. This makes the light emitting diodes not only emit high-brightness light but also have an energy and power saving effect.

Those wavelengths of light emitted by conventional light emitting diodes can be changed by using different semiconductor materials, but most of the conventional light emitting diodes have only one set of light emitting structure to emit light of a single wavelength respectively, which induces many limitations in application. In addition, although there are light emitting diodes that combine two sets of light emitting structures analogously, the two sets of light emitting structures must be made of materials with similar lattice constants (or light wavelengths) to facilitate the combination of the two sets of light emitting structures, which also causes limitations in structural design and application for the conventional light emitting diodes.

US 2007/170444 A1 describes a monolithic, multi-colored LED chip and a method for making the same.

US 2010/224857 A1 describes A multiple quantum well (MQW) structure for a light emitting diode and a method for fabricating a MQW structure for a light emitting diode.

US 2021/296528 A1 describes a display device including a light emitting unit that can emit a plurality of types of light having different wavelengths to the outside at a desired ratio with high intensity without increasing manufacturing costs in proportion to a number of pixels even when the number of pixels increases.

US 8598598 B2 describes a light emitting device having vertically stacked light emitting diodes. It comprises a lower semiconductor layer of a first conductive type positioned on a substrate, a semiconductor layer of a second conductive type on the lower semiconductor layer of a first conductive type, and an upper semiconductor layer of a first conductive type on the semiconductor layer of a second conductive type.

In light of this, it is really worthy of research and development to design a light emitting diode for solving those above-mentioned problems.

### SUMMARY OF THE INVENTION

An objective of the present invention is to provide a light emitting diode with a plurality of light emitting units.

Another objective of the present invention is to provide a light emitting diode which is able to emit light of more than one wavelength at the same time.

The invention is defined by the features of the independent claim.

To achieve the above mentioned objectives, the light emitting diode of the present invention comprises a substrate, a buffer layer and at least two light emitting units. The buffer layer is stacked on the substrate. The at least two light emitting units are sequentially layered on the buffer layer in a stacked manner. Each light emitting unit includes a semiconductor light emitting structure and a two-dimensional material layer, and the two-dimensional material layer is stacked on the semiconductor light emitting structure. Each light emitting unit emits light with a specific wavelength through the semiconductor light emitting structure respectively. Wherein the specific wavelength corresponding to one of the at least two light emitting units, which is closer to the substrate, is not smaller than the specific wavelength corresponding to the other of the at least two light emitting units, which is farther from the substrate.

**In** one embodiment of the present invention, the at least two light emitting units include a first light emitting unit and a second light emitting unit. The first light emitting unit is stacked on the buffer layer, and the second light emitting unit is stacked on a two-dimensional material layer of the first light emitting unit. A semiconductor light emitting structure of the first light emitting unit is different from a semiconductor light emitting structure of the second light emitting unit.

In one embodiment of the present invention, each semiconductor light emitting structure has a first-type semiconductor epitaxial layer, a light emitting layer and a second-type semiconductor epitaxial layer. An epitaxial stacking sequence of the first-type semiconductor epitaxial layer, the light emitting layer and the second-type semiconductor epitaxial layer of the first light emitting unit is reverse relative to an epitaxial stacking sequence of the first-type semiconductor epitaxial layer, the light emitting layer and the second-type semiconductor epitaxial layer of the second light emitting unit.

In one embodiment of the present invention, a cross-sectional area of the first light emitting unit along a horizontal direction is smaller than a cross-sectional area of the buffer layer along the horizontal direction, and a cross-sectional area of the second light emitting unit along the horizontal direction is smaller than the cross-sectional area of the first light emitting unit along the horizontal direction.

In one embodiment of the present invention, when a quantity of the light emitting units is not less than three, the semiconductor light emitting structure of any light emitting unit of the at least two the light emitting units is different from the semiconductor light emitting structure of another adjacent light emitting unit.

In one embodiment of the present invention, each semiconductor light emitting structure has a first-type semiconductor epitaxial layer, a light emitting layer and a second-type semiconductor epitaxial layer. An epitaxial stacking sequence of the first-type semiconductor epitaxial layer, the light emitting layer and the second-type semiconductor epitaxial layer of any light emitting unit is reverse relative to an epitaxial stacking sequence of the first-type semiconductor epitaxial layer, the light emitting layer and the second-type semiconductor epitaxial layer of another adjacent light emitting unit.

In one embodiment of the present invention, the buffer layer is made of a two-dimensional material.

In one embodiment of the present invention, the light emitting diode further comprises a base electrode. The base electrode is electrically connected to the buffer layer and a horizontal spacing is retained between the base electrode and the at least two light emitting units.

In one embodiment of the present invention, each light emitting unit of the at least two light emitting units further includes an additional electrode respectively. Each additional electrode is electrically connected to the two-dimensional material layer correspondingly and each additional electrode of the light emitting unit retains a horizontal spacing relative to the adjacent light emitting unit.

In the present invention, a material of the two-dimensional material layer is selected from a group of molybdenum disulfide, tungsten disulfide, molybdenum diselenide and tungsten diselenide.

In one embodiment of the present invention, the substrate is made of gallium nitride, sapphire, silicon or gallium arsenide.

By the above design, for the light emitting diode of the present invention, the multiple light emitting units are stacked into one structural component, to achieve an effect of light emitting conversion for different wavelengths of light by controlling each light emitting unit to be electrically conductive or not. Through utilizing two-dimensional materials to create conductive layer designs for different light emitting units, it effectively improves electron conductivity and reduces resistance and driving voltage between light emitting units, and makes different light emitting units with large differences in lattice constants smoothly integrate with each other.

### BRIEF DESCRIPTION OF THE DRAWINGS

FIG. 1 is a schematic view of a light emitting diode according to the present invention;
FIG. 2 is a schematic view of a first embodiment of the light emitting diode according to the present invention;
FIG. 3 is a schematic view of a second embodiment of the light emitting diode according to the present invention.

### DETAILED DESCRIPTION OF THE PREFERRED EMBODIMENT

Since various examples and embodiments in the present invention are only illustrative and non-restrictive, a person skilled in the art can easily conceive other examples and embodiments without contravening the scope of the present invention defined by the claims, after reading this specification, and can make the features and advantages of these embodiments more evident based on the following detailed description.

Herein, the description of unit, element and component in the present invention uses "one", "a", or "an". This is for convenience and for offering general meaning of the category of the present invention. Therefore, the description should be understood as including "one", "at least one", and singular and plural forms at the same time unless the context clearly indicates otherwise.

Herein, the description of the terms "first" or "second" and similar ordinal numbers are mainly used to distinguish or refer to the same or similar elements or structures and do not necessarily imply that such components or structures are spatially or temporally distinct order. It should be understood that ordinal numbers, in certain situations or configurations, may be used interchangeably without affecting the implementation of the present invention.

Herein, the description of "comprise", "have" or other similar semantics have the non-exclusive meaning. For example, components or structures with a plurality of elements are not only limited to those disclosed in this specification, but also include generally inherent elements, which are not explicitly listed here for the components or the structures.

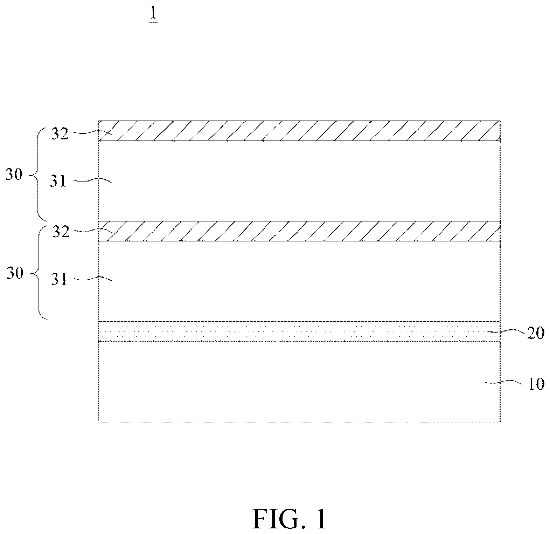

Please refer to FIG. 1, which is a schematic view of a light emitting diode of the present invention. As shown in FIG. 1, the light emitting diode 1 of the present invention mainly comprises a substrate 10, a buffer layer 20 and at least two light emitting units 30. The substrate 10 is a basic structure-component of the light emitting diode 1 of the present invention, and is used to carry the buffer layer 20, the at least two light emitting units 30 and other components. In the present invention, the substrate 10 is made of gallium nitride (GaN), sapphire, silicon (Si) or gallium arsenide (GaAs), but the substrate 10 can also be made of other common substrate materials.

The buffer layer 20 is stacked on the substrate 10. In the present invention, the buffer layer 20 is made of a two-dimensional material. Herein, the two-dimensional material is selected from a group of molybdenum disulfide (MoS2), tungsten disulfide (WS2), molybdenum diselenide (MoSe2) and tungsten diselenide (WSe2), to further form a layered structure composed of a single atomic layer or a stack of multiple atomic layers. The buffer layer 20 can also be made of other materials with similar properties of two-dimensional materials. The buffer layer 20 is adopted to handle a stress on a surface of the substrate 10, to provide a better bonding effect between the substrate 10 and the light emitting unit 30 adjacent to the substrate 10, and to bring a good effect of electrical conductivity through characteristics of high electrical conduction of two-dimensional materials.

The at least two light emitting units 30 are sequentially layered on the buffer layer 20 in a stacked manner. That is to say, except for the light emitting unit 30 adjacent to the buffer layer 20, each of the remaining light emitting units 30 is stacked on another light emitting unit 30, to form a plurality of stacked light emitting units 30. In the present invention, a quantity of the light emitting units 30 is at least two, and can be increased to more than two according to different design requirements. Each light emitting unit 30 includes a semiconductor light emitting structure 31 and a two-dimensional material layer 32. For the light emitting unit 30, the semiconductor light emitting structure 31 is a basic structure-component and is adopted to emit light with a specific wavelength after being electrically conductive. That is to say, each light emitting unit 30 independently corresponds to a specific wavelength through the semiconductor light emitting structure 31 respectively. The aforementioned specific wavelength varies depending on the material used in the semiconductor light emitting structure 31.

For each light emitting unit 30, the two-dimensional material layer 32 is stacked on the semiconductor light emitting structure 31 correspondingly. The two-dimensional material layer 32 is a single atomic layer or a layered structure formed by stacking multiple atomic layers. The two-dimensional material layer 32 is mainly used as a conductive layer, through the high electronic conductivity of the two-dimensional material, to provide a good conductive effect and also to reduce a resistance and a driving voltage between the adjacent light emitting units. Moreover, the two-dimensional material layer 32 is able to solve problems of lattice mismatch that may occur between different materials, so that different light emitting units with large differences in lattice constants (or large differences in emission wavelengths) can be smoothly integrated with each other. In the present invention, the material of the two-dimensional material layer 32 is also selected from a group of molybdenum disulfide (MoS2), tungsten disulfide (WS2), molybdenum diselenide (MoSe2), and tungsten diselenide (WSe2). For example, the same two-dimensional material as that of the aforementioned buffer layer 20 can be used, but the present invention is not limited thereto.

In terms of design, a specific wavelength corresponding to one of the at least two light emitting units 30, which is closer to the substrate 10, is not smaller than a specific wavelength corresponding to the other of the at least two light emitting units 30, which is farther from the substrate 10. Namely, for a plurality of stacked light emitting units 30, a specific wavelength corresponding to the light emitting unit 30 stacked relatively below will be greater than or equal to a specific wavelength corresponding to the light emitting unit 30 relatively stacked above. And when the two-dimensional material layer 32 of any selected light emitting unit 30 is electrically connected to the two-dimensional material layer 32 of its adjacent light emitting unit 30 thereunder, or is electrically connected to the adjacent buffer layer 20 thereunder, the selected light emitting unit 30 can correspondingly emit light of a specific wavelength through its semiconductor light emitting structure 31. Accordingly, the light emitting diode 1 of the present invention is able to drive one of or a plurality of light emitting units 30 through controlling each light emitting unit 30 to be electrically conductive or not, thereby achieving an effect of different light emitting conversion.

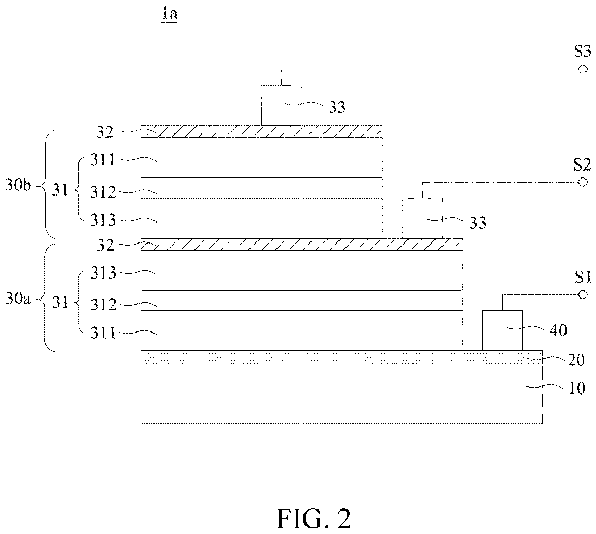

An actual structural design of the light emitting diode of the present invention will be described below. Please refer to FIG. 2, which is a schematic diagram of a first embodiment of the light emitting diode of the present invention. As shown in FIG. 2, in this embodiment, a quantity of at least two light emitting units of a light emitting diode 1a of the present invention is two. That is to say, a first light emitting unit 30a and a second light emitting unit 30b are included. The first light emitting unit 30a is stacked on the buffer layer 20, and the second light emitting unit 30b is stacked on the first light emitting unit 30a. In term of structural design, a cross-sectional area of the first light emitting unit 30a along a horizontal direction is smaller than a cross-sectional area of the substrate 10 or a cross-sectional area of the buffer layer 20 along the horizontal direction, so that the first light emitting unit 30a can be completely stacked on the buffer layer 20. A cross-sectional area of the second light emitting unit 30b along the horizontal direction is smaller than the cross-sectional area of the first light emitting unit 30a along the horizontal direction, so that the second light emitting unit 30b can be completely stacked on the first light emitting unit 30a, but not limited thereto.

In this embodiment, a semiconductor light emitting structure 31 of the first light emitting unit 30a has a first-type semiconductor epitaxial layer 311, a light emitting layer 312 and a second-type semiconductor epitaxial layer 313, and for the semiconductor light emitting structure 31, the first-type semiconductor epitaxial layer 311, the light emitting layer 312 and the second-type semiconductor epitaxial layer 313 are sequentially layered in a stacked manner. A semiconductor light emitting structure 31 of the second light emitting unit 30b also has a first-type semiconductor epitaxial layer 311, a light emitting layer 312 and a second-type semiconductor epitaxial layer 313, but for the semiconductor light emitting structure 31, the second-type semiconductor epitaxial layer 313, the light emitting layer 312 and the first-type semiconductor epitaxial layer 311 are sequentially layered in a stacked manner. Namely, the structural layers of the semiconductor light emitting structure 31 of the first light emitting unit 30a and the structural layers of the semiconductor light emitting structure 31 of the second light emitting unit 30b are exactly stacked in a reverse epitaxial stacking sequence correspondingly. For example, it is assumed that the first-type semiconductor epitaxial layer 311 is an N-type semiconductor epitaxial layer, the light emitting layer 312 is a multiple-quantum well (MQW) layer, and the second-type semiconductor epitaxial layer 313 is P-type semiconductor epitaxial layer, then the semiconductor light emitting structure 31 of the first light emitting unit 30a exhibits an N-MQW-P epitaxial stack structure and the semiconductor light emitting structure 31 of the second light emitting unit 30b exhibits a P-MQW-N epitaxial stacking structure. But the present invention is not limited thereto, the epitaxial stacking sequences of the semiconductor light emitting structure 31 of the first light emitting unit 30a and the semiconductor light emitting structure 31 of the second light emitting unit 30b can also be interchanged with each other.

In this embodiment, the light emitting diode 1a of the present invention further comprises a base electrode 40. The base electrode 40 is electrically connected to the buffer layer 20, and the base electrode 40 is connected to an external power source through a wire to conduct electricity to the buffer layer 20. In term of structural design, the base electrode 40 is also stacked on the buffer layer 20, and a horizontal spacing is retained between the base electrode 40 and the first light emitting unit 30a. The base electrode 40 is mainly made of metal materials, but the present invention is not limited thereto.

Furthermore, the first light emitting unit 30a and the second light emitting unit 30b of the light emitting diode 1a of the present invention respectively include an additional electrode 33. Each additional electrode 33 of the light emitting unit is electrically connected to the two-dimensional material layer 32 of the light emitting unit correspondingly, and the additional electrode 33 is connected to an external power source through a wire to conduct electricity to the two-dimensional material layer 32. In term of structural design, each additional electrode 33 of the light emitting unit is stacked on the two-dimensional material layer 32 of the light emitting unit correspondingly, and the additional electrode 33 of the first light emitting unit 30a and the adjacent second light emitting unit 30b retain a horizontal spacing. The additional electrode 33 is mainly made of metal materials, but not limited thereto.

In this embodiment, it is assumed that the specific wavelength corresponding to the first light emitting unit 30a is λ1, the specific wavelength corresponding to the second light emitting unit 30b is λ2, and λ1≧λ2. In term of circuit design, for the light emitting diode 1a of the present invention, the base electrode 40 connects to a switch S1 through a wire, the additional electrode 33 of the first light emitting unit 30a connects to a switch S2 through a wire, and the additional electrode 33 of the second light emitting unit 30b connects to a switch S3 through a wire. When only the switch S1 and the switch S2 are turned on, namely in a conducting state respectively (S1 and S2 shown as ON and S3 shown as OFF in Table 1), the light emitting diode 1a of the present invention emits light with the specific wavelength of λ1 through the first light emitting unit 30a. When only the switch S2 and the switch S3 are turned on, the light emitting diode 1a of the present invention emits light with the specific wavelength of λ2 through the second light emitting unit 30b. And when the switch S1, the switch S2 and the switch S3 are all turned on, the light emitting diode 1a of the present invention emits light with the specific wavelengths of λ1 and λ2 through the first light emitting unit 30a and the second light emitting unit 30b simultaneously. For the aforementioned switch controls and corresponding lighting effects, please refer to Table 1 below. Accordingly, the light emitting diode 1a of the present invention can selectively drive one light emitting unit to emit light alone or multiple light emitting units to emit light simultaneously, so as to provide an effect of different light emitting conversion.

**Table 1**

| Specific wavelength(s) | Switch S1 | Switch S2 | Switch S3 |
|---|---|---|---|
| λ1 | ON | ON | OFF |
| λ2 | OFF | ON | ON |
| λ1 &λ2 | ON | ON | ON |

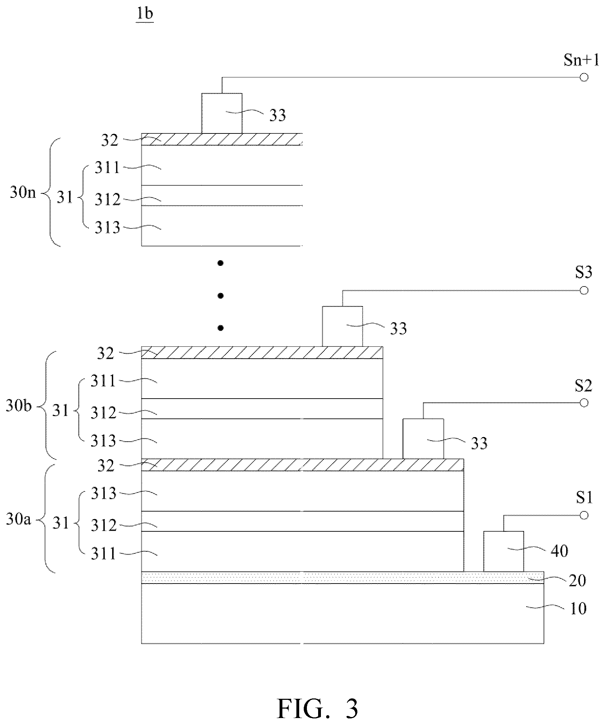

Please refer to FIG. 3, which is a schematic diagram of a second embodiment of the light emitting diode of the present invention. As shown in FIG. 3, in this embodiment, a quantity of at least two light emitting units of a light emitting diode 1b of the present invention is n. Namely, a first light emitting unit 30a, a second light emitting unit 30b, ... and an n^{th} light emitting unit are included, wherein n is a positive integer and n≧3. The first light emitting unit 30a is stacked on a buffer layer 20, the second light emitting unit 30b is stacked on the first light emitting unit 30a, ..., and the n^{th} light emitting unit 30n is stacked on the (n-1)^{th} light emitting unit (when n=3, the (n-1)^{th} light emitting unit is the second light emitting unit 30b). In term of structural design, a cross-sectional area of the first light emitting unit 30a along a horizontal direction is smaller than a cross-sectional area of the substrate 10 or a cross-sectional area of the buffer layer 20 along the horizontal direction, so that the first light emitting unit 30a can be completely stacked on the buffer layer 20; a cross-sectional area of the second light emitting unit 30b along the horizontal direction is smaller than the cross-sectional area of the first light emitting unit 30a along the horizontal direction, so that the second light emitting unit 30b can be completely stacked on the first light emitting unit 30a; ... ; and a cross-sectional area of the n^{th} light emitting unit 30n along the horizontal direction is smaller than a cross-sectional area of the (n-1)^{th} light emitting unit along the horizontal direction, so that the n^{th} light emitting unit 30n can be completely stacked on the (n-1)^{th} light emitting unit.

When the quantity of the at least two light emitting units is not less than three, the semiconductor light emitting structure of any of the at least two light emitting units is different from the semiconductor light emitting structure of its adjacent light emitting unit. In this embodiment, for a semiconductor light emitting structure 31 of the first light emitting unit 30a, a first-type semiconductor epitaxial layer 311, a light emitting layer 312 and a second-type semiconductor epitaxial layer 313 are sequentially layered in a stacked manner. For a semiconductor light emitting structure 31 of the second light emitting unit 30b, a second-type semiconductor epitaxial layer 313, a light emitting layer 312 and a first-type semiconductor epitaxial layer 311 are sequentially layered in a stacked manner. After the second light emitting unit 30b, when a subsequently stacked light emitting unit is with an odd ordinal (such as the third light emitting unit, the fifth light emitting unit, ..., and so on), its semiconductor light emitting structures is as same as the semiconductor light emitting structure 31 of the first light emitting unit 30a, wherein a first-type semiconductor epitaxial layer 311, a light emitting layer 312 and a second-type semiconductor epitaxial layer 313 are sequentially layered in a stacked manner; and when a subsequently stacked light emitting unit is with an even ordinal (such as the fourth light emitting unit, the sixth light emitting unit, ..., and so on), its semiconductor light emitting structure is as same as the semiconductor light emitting structure 31 of the second light emitting unit 30b, wherein a second-type semiconductor epitaxial layer 313, a light emitting layer 312 and a first-type semiconductor epitaxial layer 311 are sequentially layered in a stacked manner. That is to say, when the quantity of light emitting units is not less than three, an epitaxial stacking sequence of the first-type semiconductor epitaxial layer, the light emitting layer and the second-type semiconductor epitaxial layer of any of the light emitting units is reverse relative to an epitaxial stacking sequence of the first-type semiconductor epitaxial layer, the light emitting layer and the second-type semiconductor epitaxial layer of its adjacent light emitting unit. For example, it is assumed that the semiconductor light emitting structures of all of the light emitting units with odd ordinals respectively exhibit an epitaxial stacked structure as N-MQW-P and the semiconductor light emitting structures of all of the light emitting units with even ordinals respectively exhibit an epitaxial structure of P-MQW-N, but not limited thereto.

In this embodiment, the light emitting diode 1b of the present invention also comprises a base electrode 40, an arrangement of the base electrode 40 is the same as that in the first embodiment, and will not be described again. In addition, the first light emitting unit 30a, the second light emitting unit 30b, ... and the n^{th} light emitting unit 30n of the light emitting diode 1b of the present invention respectively include an additional electrode 33. Correspondingly, each additional electrode 33 of the light emitting unit is electrically connected to a two-dimensional material layer 32 of the light emitting unit, and each additional electrode 33 is connected to an external power source through a wire to conduct electricity to each two-dimensional material layer 32. In term of structural design, each additional electrode 33 of the light emitting unit is correspondingly stacked on the two-dimensional material layer 32 of the light emitting unit, and a spacing is retained between the additional electrode 33 of the first light emitting unit 30a and the second light emitting unit 30b, ..., and a spacing is retained between the additional electrode 33 of the (n-1)^{th} light emitting unit and the n^{th} light emitting unit 30n.

In this embodiment, it is assumed that a specific wavelength corresponding to the first light emitting unit 30a is λ1, a specific wavelength corresponding to the second light emitting unit 30b is λ2, ..., a specific wavelength corresponding to the n^{th} light emitting unit 30n is λn, and λ1≧λ2≧...≧λn. In term of circuit design, for the light emitting diode 1b of the present invention, the base electrode 40 is connected to a switch S1 through a wire, the additional electrode 33 of the first light emitting unit 30a is connected to a switch S2 through a wire, the additional electrode 33 of the second light emitting unit 30b is connected to a switch S3 through a wire, ..., and the additional electrode 33 of the n^{th} light emitting unit 30n is connected to a switch Sn+1 through a wire. When only the switch S1 and the switch S2 are turned on, the light emitting diode 1b of the present invention emits light with the specific wavelength of λ1 through the first light emitting unit 30a; when only the switch S2 and the switch S3 are turned on, the light emitting diode 1b of the present invention emits light with the specific wavelength of λ2 through the second light emitting unit 30b; ...; and when only the switch Sn (when n=3, the switch Sn is the switch S3) and the switch Sn+1 are turned on, the light emitting diode 1b of the present invention emits light with the specific wavelength of λn through the n^{th} light emitting unit 30n. Furthermore, when only the switch S1, the switch S2 and the switch S3 are turned on, the light emitting diode 1b of the present invention simultaneously emits light with the specific wavelengths of λ1 and λ2 through the first light emitting unit 30a and the second light emitting unit 30b; when only the switch S1, the switch S2, the switch Sn and the switch Sn+1 are turned on, the light emitting diode 1b of the present invention simultaneously emits light with the specific wavelengths of λ1 and λn through the first light emitting unit 30a and the n^{th} light emitting unit 30n; ...; and when all the switches S1 to Sn+1 are turned on, the light emitting diode 1b of the present invention emits the specific wavelengths of λ1, λ2, ..., and λn simultaneously through the first light emitting unit 30a to the n^{th} light emitting unit 30n. For the aforementioned switch controls and corresponding lighting effects, please refer to Table 2 below. Accordingly, the light emitting diode 1b of the present invention is able to selectively drive one light emitting unit to emit light alone or multiple light emitting units to emit light simultaneously, so as to provide an effect of different light emitting conversion.

**Table 2**

| Specific | Switch | Switch | Switch | ... | Switch | Switch Sn+1 |
|---|---|---|---|---|---|---|
| wavelength(s) | S1 | S2 | S3 | | Sn | |
| λ1 | ON | ON | OFF | | OFF | OFF |
| λ2 | OFF | ON | ON | | OFF | OFF |
| λ1 &λ2 | ON | ON | ON | | OFF | OFF |
| λ1 &λn | ON | ON | OFF | | ON | ON |
| ⋮ | | | | | | |
| λ1 &λ2 &...&λn | ON | ON | ON | ... | ON | ON |

The above implementations are only auxiliary descriptions, and are not intended to limit the embodiments of the application subject or the applications or uses of the embodiments. In addition, although at least one illustrative example has been presented above, it should be understood that the present invention can still have a large quantity of variations. It should also be understood that the embodiments described herein are not intended to limit the scope, use, or configuration of the requested subject matter in any way. On the contrary, the foregoing embodiments will provide a convenient guide for those skilled in the art to implement one or more embodiments. Furthermore, various changes can be made to the function and arrangement of the components without departing from the scope defined by the claims.

## Claims

1. A light emitting diode (1), comprising:
a substrate (10),
a buffer layer (20), stacked on the substrate (10), and
at least two light emitting units (30), sequentially layered on the buffer layer (20) in a stacked manner, wherein each light emitting unit (30) includes a semiconductor light emitting structure (31) and a two-dimensional material layer (32), and the two-dimensional material layer (32) is stacked on the semiconductor light emitting structure (31), and wherein each light emitting unit (30) emits light with a specific wavelength through the semiconductor light emitting structure (31) respectively, wherein
the specific wavelength corresponding to one of the at least two light emitting units (30), which is closer to the substrate (10), is not smaller than the specific wavelength corresponding to the other of the at least two light emitting units (30), which is farther from the substrate (10), each two-dimensional material layer (32) and the buffer layer (20) are made of a two-dimensional material selected from a group of molybdenum disulfide, tungsten disulfide, molybdenum diselenide, and tungsten diselenide, and
each two-dimensional material layer (32) and the buffer layer (20) is a layered structure composed of a single atomic layer or a stack of multiple atomic layers.

2. The light emitting diode (1) as claimed in claim 1, wherein the at least two light emitting units (30) include a first light emitting unit (30a) and a second light emitting unit (30b), wherein the first light emitting unit (30a) is stacked on the buffer layer (20), the second light emitting unit (30b) is stacked on a two-dimensional material layer (32) of the first light emitting unit (30a), and wherein a semiconductor light emitting structure (31) of the first light emitting unit (30a) is different from a semiconductor light emitting structure (31) of the second light emitting unit (30b).

3. The light emitting diode (1) as claimed in claim 2, wherein each semiconductor light emitting structure (31) has a first-type semiconductor epitaxial layer (311), a light emitting layer (312) and a second-type semiconductor epitaxial layer (313), and wherein an epitaxial stacking sequence of the first-type semiconductor epitaxial layer (311), the light emitting layer (312) and the second-type semiconductor epitaxial layer (313) of the first light emitting unit (30a) is reverse relative to an epitaxial stacking sequence of the first-type semiconductor epitaxial layer (311), the light emitting layer (312) and the second-type semiconductor epitaxial layer (313) of the second light emitting unit (30b).

4. The light emitting diode (1) as claimed in claim 2, wherein a cross-sectional area of the first light emitting unit (30a) along a horizontal direction is smaller than a cross-sectional area of the buffer layer (20) along the horizontal direction, and a cross-sectional area of the second light emitting unit (30b) along the horizontal direction is smaller than the cross-sectional area of the first light emitting unit (30a) along the horizontal direction.

5. The light emitting diode (1) as claimed in claim 1, wherein when a quantity of the light emitting units (30) is not less than three, the semiconductor light emitting structure (31) of any light emitting unit of the at least two the light emitting units (30) is different from the semiconductor light emitting structure (31) of another adjacent light emitting unit.

6. The light emitting diode (1) as claimed in claim 5, wherein each semiconductor light emitting structure (31) has a first-type semiconductor epitaxial layer (311), a light emitting layer (312) and a second-type semiconductor epitaxial layer (313), and wherein an epitaxial stacking sequence of the first-type semiconductor epitaxial layer (311), the light emitting layer (312) and the second-type semiconductor epitaxial layer (313) of any light emitting unit is reverse relative to an epitaxial stacking sequence of the first-type semiconductor epitaxial layer (311), the light emitting layer (312) and the second-type semiconductor epitaxial layer (313) of another adjacent light emitting unit.

7. The light emitting diode (1) as claimed in claim 1, further comprising a base electrode (40), wherein the base electrode (40) is electrically connected to the buffer layer (20) and a horizontal spacing is retained between the base electrode (40) and the at least two light emitting units (30).

8. The light emitting diode (1) as claimed in claim 1, wherein each light emitting unit of the at least two light emitting units (30) further includes an additional electrode respectively and each additional electrode (33) is electrically connected to the two-dimensional material layer (32) correspondingly, and wherein each additional electrode (33) of the light emitting unit retains a horizontal spacing relative to the adjacent light emitting unit.

9. The light emitting diode (1) as claimed in claim 1, wherein the substrate (10) is made of gallium nitride, sapphire, silicon or gallium arsenide.

## Patentansprüche

1. Leuchtdiode (1), aufweisend:
ein Substrat (10);
eine auf dem Substrat (10) aufgebrachte Pufferschicht (20); und
mindestens zwei lichtemittierende Einheiten (30), die nacheinander stapelförmig auf die Pufferschicht (20) aufgebracht sind, wobei jede lichtemittierende Einheit (30) eine Halbleiter-Lichtemissionsstruktur (31) und eine Schicht (32) aus einem zweidimensionalen Material aufweist, und wobei die Schicht (32) aus einem zweidimensionalen Material auf der Halbleiter-Lichtemissionsstruktur (31) aufgebracht ist, und wobei jede lichtemittierende Einheit (30) jeweils Licht mit einer spezifischen Wellenlänge durch die Halbleiter-Lichtemissionsstruktur (31) emittiert, wobei
die spezifische Wellenlänge, die einer der mindestens zwei lichtemittierenden Einheiten (30) entspricht, die näher am Substrat (10) liegt, nicht kleiner ist als die spezifische Wellenlänge, die der anderen der mindestens zwei lichtemittierenden Einheiten (30) entspricht, die weiter vom Substrat (10) entfernt ist,
jede unter der Schicht (32) aus einem zweidimensionalen Material und der Pufferschicht (20) aus einem zweidimensionalen Material hergestellt ist, das ausgewählt ist aus einer Gruppe bestehend aus Molybdändisulfid, Wolframdisulfid, Molybdändiselenid und Wolframdiselenid, und
jede unter der Schicht (32) aus einem zweidimensionalen Material und der Pufferschicht (20) eine Schichtstruktur ist, die aus einer einzelnen Atomschicht oder einem Stapel aus mehreren Atomschichten besteht.

2. Leuchtdiode (1) nach Anspruch 1, wobei die mindestens zwei lichtemittierenden Einheiten (30) eine erste lichtemittierende Einheit (30a) und eine zweite lichtemittierende Einheit (30b) aufweisen, wobei die erste lichtemittierende Einheit (30a) auf der Pufferschicht (20) aufgebracht ist, die zweite lichtemittierende Einheit (30b) auf einer Schicht (32) aus einem zweidimensionalen Material der ersten lichtemittierenden Einheit (30a) aufgebracht ist, und wobei sich eine Halbleiter-Lichtemissionsstruktur (31) der ersten lichtemittierenden Einheit (30a) von einer Halbleiter-Lichtemissionsstruktur (31) der zweiten lichtemittierenden Einheit (30b) unterscheidet.

3. Leuchtdiode (1) nach Anspruch 2, wobei jede Halbleiter-Lichtemissionsstruktur (31) eine Epitaxieschicht (311) eines Halbleiters eines ersten Typs, eine Lichtemissionsschicht (312) und eine Epitaxieschicht (313) eines Halbleiters eines zweiten Typs aufweist, und wobei eine Epitaxie-Schichtfolge der Epitaxieschicht (311) des Halbleiters des ersten Typs, der Lichtemissionsschicht (312) und der Epitaxieschicht (313) des Halbleiters des zweiten Typs der ersten lichtemittierenden Einheit (30a) in Bezug auf eine Epitaxie-Schichtfolge der Epitaxieschicht (311) des Halbleiters des ersten Typs, der Lichtemissionsschicht (312) und der Epitaxieschicht (313) des Halbleiters des zweiten Typs der zweiten lichtemittierenden Einheit (30b) umgekehrt ist.

4. Leuchtdiode (1) nach Anspruch 2, wobei eine Querschnittsfläche der ersten lichtemittierenden Einheit (30a) entlang einer horizontalen Richtung kleiner ist als eine Querschnittsfläche der Pufferschicht (20) entlang der horizontalen Richtung, und wobei eine Querschnittsfläche der zweiten lichtemittierenden Einheit (30b) entlang der horizontalen Richtung kleiner ist als die Querschnittsfläche der ersten lichtemittierenden Einheit (30a) entlang der horizontalen Richtung.

5. Leuchtdiode (1) nach Anspruch 1, wobei, wenn die Anzahl der lichtemittierenden Einheiten (30) nicht kleiner ist als drei, die Halbleiter-Lichtemissionsstruktur (31) einer beliebigen lichtemittierenden Einheit der mindestens zwei lichtemittierenden Einheiten (30) sich von der Halbleiter-Lichtemissionsstruktur (31) einer anderen benachbarten lichtemittierenden Einheit unterscheidet.

6. Leuchtdiode (1) nach Anspruch 5, wobei jede Halbleiter-Lichtemissionsstruktur (31) eine Epitaxieschicht (311) eines Halbleiters eines ersten Typs, eine Lichtemissionsschicht (312) und eine Epitaxieschicht (313) eines Halbleiters eines zweiten Typs aufweist, und wobei eine Epitaxie-Schichtfolge der Epitaxieschicht (311) des Halbleiters des ersten Typs, der Lichtemissionsschicht (312) und der Epitaxieschicht (313) des Halbleiters des zweiten Typs einer beliebigen lichtemittierenden Einheit in Bezug auf eine Epitaxie-Schichtfolge der Epitaxieschicht (311) des Halbleiters des ersten Typs, der Lichtemissionsschicht (312) und der Epitaxieschicht (313) des Halbleiters des zweiten Typs einer anderen benachbarten lichtemittierenden Einheit umgekehrt ist.

7. Leuchtdiode (1) nach Anspruch 1, ferner aufweisend eine Basiselektrode (40), wobei die Basiselektrode (40) elektrisch mit der Pufferschicht (20) verbunden ist und ein horizontaler Abstand zwischen der Basiselektrode (40) und den mindestens zwei lichtemittierenden Einheiten (30) beibehalten wird.

8. Leuchtdiode (1) nach Anspruch 1, wobei jede lichtemittierende Einheit der mindestens zwei lichtemittierenden Einheiten (30) ferner jeweils eine zusätzliche Elektrode aufweist und jede zusätzliche Elektrode (33) entsprechend mit der Schicht (32) aus einem zweidimensionalen Material elektrisch verbunden ist, und wobei jede zusätzliche Elektrode (33) der lichtemittierenden Einheit einen horizontalen Abstand relativ zur benachbarten lichtemittierenden Einheit beibehält.

9. Leuchtdiode (1) nach Anspruch 1, wobei das Substrat (10) aus Galliumnitrid, Saphir, Silizium oder Galliumarsenid hergestellt ist.

## Revendications

1. Diode électroluminescente (1), comprenant :
un substrat (10),
une couche tampon (20), empilée sur le substrat(10), et
au moins deux unités photo-émettrices (30), stratifiées séquentiellement sur la couche tampon (20) de manière empilée, dans laquelle chaque unité photo-émettrice (30) inclut une structure de semi-conducteur photo-émettrice (31) et une couche de matière bidimensionnelle (32), et la couche de matière bidimensionnelle (32) est empilée sur la structure de semi-conducteur photo-émettrice (31), et dans laquelle chaque unité photo-émettrice (30) émet respectivement de la lumière avec une longueur d'onde spécifique à travers la structure de semi-conducteur photo-émettrice (31), dans laquelle
la longueur d'onde spécifique correspondant à l'une des au moins deux unités photo-émettrices (30), qui est plus proche du substrat (10), n'est pas inférieure à la longueur d'onde spécifique correspondant à l'autre des au moins deux unités photo-émettrices (30), qui est plus éloignée du substrat (10),
chaque couche de matière bidimensionnelle (32) et la couche tampon (20) sont fabriquées en une matière bidimensionnelle choisie dans un groupe constitué par le disulfure de molybdène, le disulfure de tungstène, le diséléniure de molybdène et le diséléniure de tungstène, et
chaque couche de matière bidimensionnelle (32) et la couche tampon (20) sont une structure stratifiée composée d'une unique couche atomique ou d'un empilement de plusieurs couches atomiques.

2. Diode électroluminescente (1) selon la revendication 1, dans laquelle les au moins deux unités photo-émettrices (30) incluent une première unité photo-émettrice (30a) et une deuxième unité photo-émettrice (30b), dans laquelle la première unité photo-émettrice (30a) est empilée sur la couche tampon (20), la deuxième unité photo-émettrice (30b) est empilée sur une couche de matière bidimensionnelle (32) de la première unité photo-émettrice (30a), et dans laquelle une structure de semi-conducteur photo-émettrice (31) de la première unité photo-émettrice (30a) est différente d'une structure de semi-conducteur photo-émettrice (31) de la deuxième unité photo-émettrice (30b).

3. Diode électroluminescente (1) selon la revendication 2, dans laquelle chaque structure de semi-conducteur photo-émettrice (31) a une couche de semi-conducteur épitaxiée d'un premier type (311), une couche photo-émettrice (312) et une couche de semi-conducteur épitaxiée d'un second type (313), et dans laquelle une séquence d'empilement épitaxié de la couche de semi-conducteur épitaxiée d'un premier type (311), de la couche photo-émettrice (312) et de la couche de semi-conducteur épitaxiée d'un second type (313) de la première unité photo-émettrice (30a) est inversée par rapport à une séquence d'empilement épitaxié de la couche de semi-conducteur épitaxiée d'un premier type (311), de la couche photo-émettrice (312) et de la couche de semi-conducteur épitaxiée d'un second type (313) de la deuxième unité photo-émettrice (30b).

4. Diode électroluminescente (1) selon la revendication 2, dans laquelle une aire de section transversale de la première unité photo-émettrice (30a) le long d'une direction horizontale est inférieure à une aire de section transversale de la couche tampon (20) le long de la direction horizontale, et une aire de section transversale de la deuxième unité photo-émettrice (30b) le long de la direction horizontale est inférieure à l'aire de section transversale de la première unité photo-émettrice (30a) le long de la direction horizontale.

5. Diode électroluminescente (1) selon la revendication 1, dans laquelle lorsqu'une quantité des unités photo-émettrices (30) n'est pas inférieure à trois, la structure de semi-conducteur photo-émettrice (31) de l'une quelconque des unités photo-émettrices parmi les au moins deux unités photo-émettrices (30) est différente de la structure de semi-conducteur photo-émettrice (31) d'une autre unité photo-émettrice adjacente.

6. Diode électroluminescente (1) selon la revendication 5, dans laquelle chaque structure de semi-conducteur photo-émettrice (31) a une couche de semi-conducteur épitaxiée d'un premier type (311), une couche photo-émettrice (312) et une couche de semi-conducteur épitaxiée d'un second type (313), et dans laquelle une séquence d'empilement épitaxié de la couche de semi-conducteur épitaxiée d'un premier type (311), de la couche photo-émettrice (312) et de la couche de semi-conducteur épitaxiée d'un second type (313) de l'une quelconque des unités photo-émettrices est inversée par rapport à une séquence d'empilement épitaxié de la couche de semi-conducteur épitaxiée d'un premier type (311), de la couche photo-émettrice (312) et de la couche de semi-conducteur épitaxiée (313) d'une autre unité photo-émettrice adjacente.

7. Diode électroluminescente (1) selon la revendication 1, comprenant en outre une électrode de base (40), dans laquelle l'électrode de base (40) est connectée électriquement à la couche tampon (20) et un espacement horizontal est retenu entre l'électrode de base (40) et les au moins deux unités photo-émettrices (30).

8. Diode électroluminescente (1) selon la revendication 1, dans laquelle chaque unité photo-émettrice parmi les au moins deux unités photo-émettrices (30) inclut respectivement en outre une électrode supplémentaire et chaque électrode supplémentaire (33) est connectée électriquement à la couche de matière bidimensionnelle (32) de manière correspondante, et dans laquelle chaque électrode supplémentaire (33) de l'unité photo-émettrice retient un espacement horizontal par rapport à l'unité photo-émettrice adjacente.

9. Diode électroluminescente (1) selon la revendication 1, dans laquelle le substrat (10) est fabriqué en nitrure de gallium, en saphir, en silicium ou en arséniure de gallium.
